Europäisches Patentamt

European Patent Office

Office européen des brevets

(11) Publication number: **0 139 185**

A2

(12) **EUROPEAN PATENT APPLICATION**

(21) Application number: **84110355.9**

(22) Date of filing: **30.08.84**

(51) Int. Cl.⁴: **G 11 C 17/00**

(30) Priority: **09.09.83 US 530981**

(43) Date of publication of application:
**02.05.85 Bulletin 85/18**

(84) Designated Contracting States:
**BE DE FR GB IT NL**

(71) Applicant: EXEL MICROELECTRONICS, INC.
2150 Commerce Drive
San Jose, Cal. 95131(US)

(72) Inventor: Zeman, Richard Joseph
471 Washington Street
Santa Clara, Cal. 95050(US)

(72) Inventor: Gupta, Anil
801-L West California Avenue
Sunnyvale Cal. 94086(US)

(74) Representative: Reinländer & Bernhardt Patentanwälte
Orthstrasse 12
D-8000 München 60(DE)

(54) A high speed memory device and a method therefor.

(57) The present invention relates to a method and an apparatus for an improved electrically programmable read only memory device. Each device comprises a plurality of addressable bits with each bit having two storage cells. If one of the storage cells is charged and the other is uncharged, then the bit is in one logical state; if the one cell is uncharged and the other is charged, then the bit is in the other logical state. Voltage from the storage cells are detected differentially. As a result, greater speed in readout of the device can be achieved.

FIG.__4.

EP 0 139 185 A2

0139185

## Description
## A High Speed Memory Device And A Method Therefor

### Technical Field

The present invention relates to a high speed memory device and a method for operating a memory device to achieve high speed. More particularly, the present invention relates to a high speed electrically erasable programmable or electrically programmable read only memory device.

### Background Of The Invention

An Electrically Programmable Read Only Memory (EPROM) device is well-known in the art. An EPROM device provides non-volatile data storage. Each cell of an EPROM device can be programmed like a PROM with high voltage pulses. However, the EPROM device can be erased with ultra-violet light. Typically, the EPROM device comprises a plurality of addressable storage transistors, with each storage transistor having a floating polysilicon gate. The floating gate is positioned between the electrical gate connection and the substrate. Charges are stored on this "floating" gate and changes the transistor characteristics. When the transistor is selected to read data, if there is no charge on the floating gate, then current will conduct from the drain to the source when a low voltage (such as +5V or lower) is applied. On the other hand, if the gate is charged, then the transistor will not conduct current from the drain to the source with a low voltage. Thus, a logical "0" or "1" condition can be represented.

The charge on the floating gate of an EPROM device is deposited at the user's discretion. Selected transistors can be programmed to have the floating gate charged, thereby representing a logical "0" state.

Charge can be removed by exposing the EPROM device to ultra-violet light, resulting in a logical "1" state. When data is read from the storage transistor, the charge stored on the floating gate is not affected. Thus, the reading of the logical state of the storage transistor is non-destructive.

An Electrically Erasable Programmable Read Only Memory (EEPROM) device is also well-known in the art. In the EEPROM device, the EEPROM device takes advantage of the basic EPROM transistor structure. The only difference is that there is a thin tunnel oxide region above the drain of the floating gate transistor. This thin oxide region allows charges to move bidirectionally under the influence of an electric field, either onto or off the floating gate. By applying a high voltage to the transistor's electrical gate connection and a low voltage to the transistor's electrical drain connection, charges can be induced to pass through the tunnel oxide region onto the floating gate. Using the same principle in reverse, the charges can be electrically removed from the floating gate. In this manner, charges can be added or subtracted from the floating gate, electrically. Thus, the writing of data into an EEPROM device does not necessitate exposing the device to ultra-violet light and can be incorporated into the same circuit as the reading of the device. The reading of the EEPROM device occurs under the same principles as the EPROM device in that it is non-destructive and non-volatile.

A static Random Access Memory (RAM) is well-known in the art. A static RAM comprises a plurality of storage bits. Each bit comprises six (6) transistors connected in a flip-flop like manner in two (2) bit lines. The current from the two bit lines are passed through a differential voltage sensor which senses the difference in the amount of voltage through the two bit lines.  One bit line will have more voltage than the other bit line representing a logical state; or the other bit line will have more voltage than the one bit line representing the other logical state.

## Brief Description Of The Drawings

Fig. 1 is a schematic circuit diagram of an EPROM of the prior art.

Fig. 2 is a schematic circuit diagram of an EEPROM of the prior art.

Fig. 3 is a schematic circuit diagram of a static RAM of the prior art.

Fig. 4 is a schematic circuit diagram of a memory device of the present invention.

Fig. 5 is a schematic circuit diagram of another embodiment of the memory device of the present invention.

## Detailed Description Of The Drawings

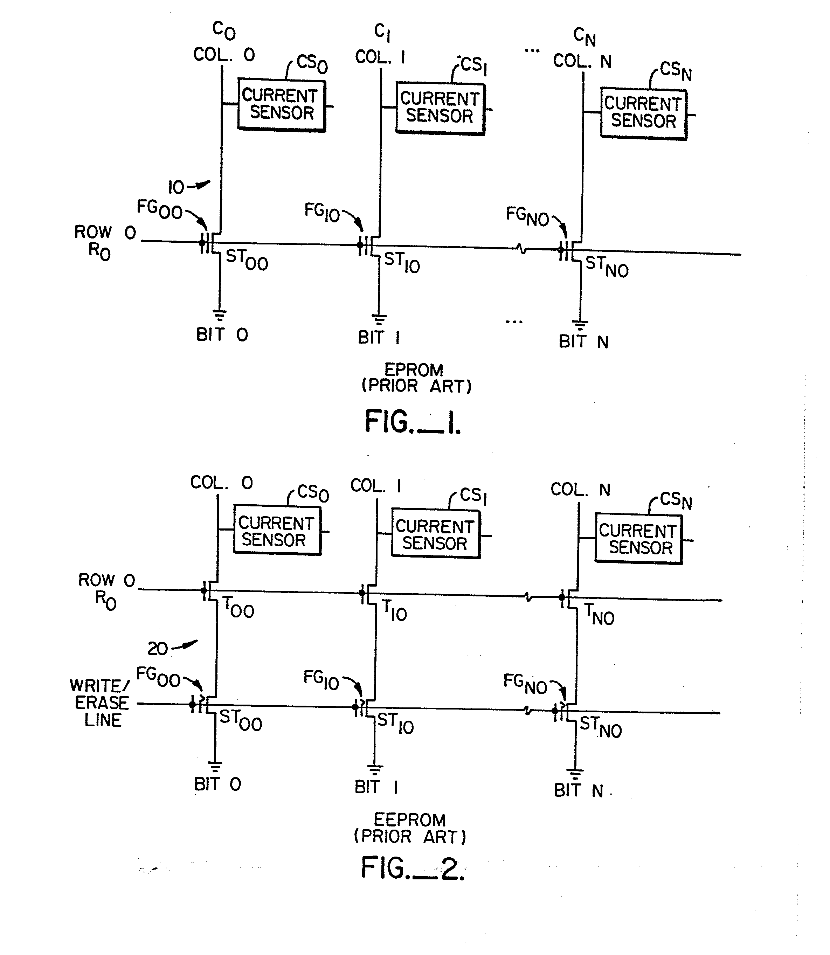

Referring to Fig. 1, there is shown an EPROM memory device 10 of the prior art.  The EPROM memory device 10 comprises a plurality of column selectors $(C_O, C_1, \ldots C_n)$, and a plurality of row selectors $(R_0, R_1 \ldots R_M)$ (only one row $R_0$ is shown).  At the intersection of each column and each row is a storage transistor $ST_{ij}$ (where i represents the number in the column, and j represents the number in the row).  The row line $R_0$ is connected to the gate of the storage transistor $ST_{ij}$.  Each storage transistor $ST_{ij}$ is characterized by a floating gate $FG_{ij}$ as previously discussed.  The storage transistors $ST_{ij}$ are all fabricated from integrated circuit techniques using MOS technology.  The transistors are of the FET type and are typically all fabricated on a single chip.

Each column $C_i$ has a current sensor $CS_i$ associated therewith, for detecting the amount of current from the associated storage transistor $ST_{ij}$.

In the write mode, the entire EPROM memory device 10 is exposed to UV or ultra-violet radiation. The ultra-violet radiation drains the charges from the floating gate $FG_{ij}$ of all the storage transistors $ST_{ij}$. By exposing the EPROM 10 to ultra-violet light, charges on all the floating gates $FG_{ij}$ are removed. When the floating gate $FG_{ij}$ of a storage transistor $ST_{ij}$ is depleted of charges, current will conduct from the drain to the source of that storage transistor $ST_{ij}$. This is a logical "1" condition. Thus, the exposure of the EPROM 10 to ultra-violet light will program all of the bits in every column and row to the logical state of "1".

To selectively program the desired bits into the logical state "0", the particular row and column is selected. A high voltage source (typically +21 volts) is applied to the desired row and column. The high voltage, which is applied to the gate of the selected storage transistor ST, causes charges to be placed onto the floating gate FG of the selected storage transistor ST. When charge is present on the floating gate FG, the storage transistor ST will not conduct current from the drain to the source. Thus, the storage transistor ST represents a logical "0" state. Therefore, by first exposing the EPROM 10 to UV light and, subsequently, placing charge on the desired storage transistor ST, the EPROM 10 device can be programmed.

In the read mode, a low voltage (typically, +5V or lower) is supplied to the particular column and row. The associated Current Sensor $CS_i$ for the bit chosen detects the amount of current passing from the storage transistor $ST_{ij}$. Since the amount of current flowing through the storage transistor $ST_{ij}$ is small, (on the order of 50 microampere or less), the Current Sensor (CS) must be operated over a relatively long period of time to ensure that the current detected from the storage transistor ST is representative of the logical state of the storage transistor ST. Typically, the Current Sensor (CS) senses for approximately 100-150 nsec.

Referring to Fig. 2, there is shown an EEPROM memory device 20 of the prior art. The EEPROM memory device 20 is identical to the EPROM memory device 10, shown in Fig. 1, with the exception of the character of the floating gate FG associated with each storage transistor ST and the addition of a select transistor $T_{ij}$ at the intersection of each column and row. A relatively thin region of oxide of less than 200 angstroms thick is applied between the floating gate FG and the drain. Using the Fowler-Nordhein mechanism, electrons are tunnelled from the drain to the floating gate, and vice versa. When a high voltage (typically, +21V) is applied to the top gate, while the drain is kept at ground potential, the electrical field in the thin oxide region is directed from the floating gate FG to the drain region, such that electrons tunnel through the oxide and are stored on the floating gate FG. On the other hand, if a high voltage is applied to the drain and the top gate is tied to ground potential, electrons are depleted from the floating gate FG. The effect of charges being present or absent on the floating gate is somewhat similar to the mechanism discussed with the EPROM memory deivce 10. If electrons are present on the floating gate FG of an EEPROM memory device 20, the storage transistor ST shuts off the current flow between the source and the drain and is representative of a logical state of "1". On the other hand, when charges are substantially depleted from the floating gate FG, current is permitted to passed from the drain to the source, the storage transistor represents a logical state of "0".

In the write mode, each of the storage transistors ST in the EEPROM memory device 20 is charged by placing electrons on the floating gate FG. That is, all the rows are brought to a high voltage source, such as +21V, all the columns are brought to a low voltage (such as 0 volts) and each of the write line $W_j$ associated with a row line is also brought to a high voltage source. Thereafter, electrons are selectively removed from the floating gate FG of those transistors in the selected row and column in which it is desired that the storage transistor ST represent a logical state of "0". This is accomplished by placing a source of high voltage, i.e., +21V, to the selected row and desired column and placing zero volt on the write line. This depletes the charge from the floating gate FG of the selected transistor ST.

In the read mode, a low voltage, such as +5V or lower, is placed on the selected row and column. Similar to the EPROM memory device 10, a Current Sensor $CS_i$, associated with each column, senses the amount of current from the selected storage transistor $ST_{ij}$. Again, because the amount of charge passing through each storage transistor ST is low, the current sensor must sense for a relatively long period of time (typically, 100-150 nsec.).

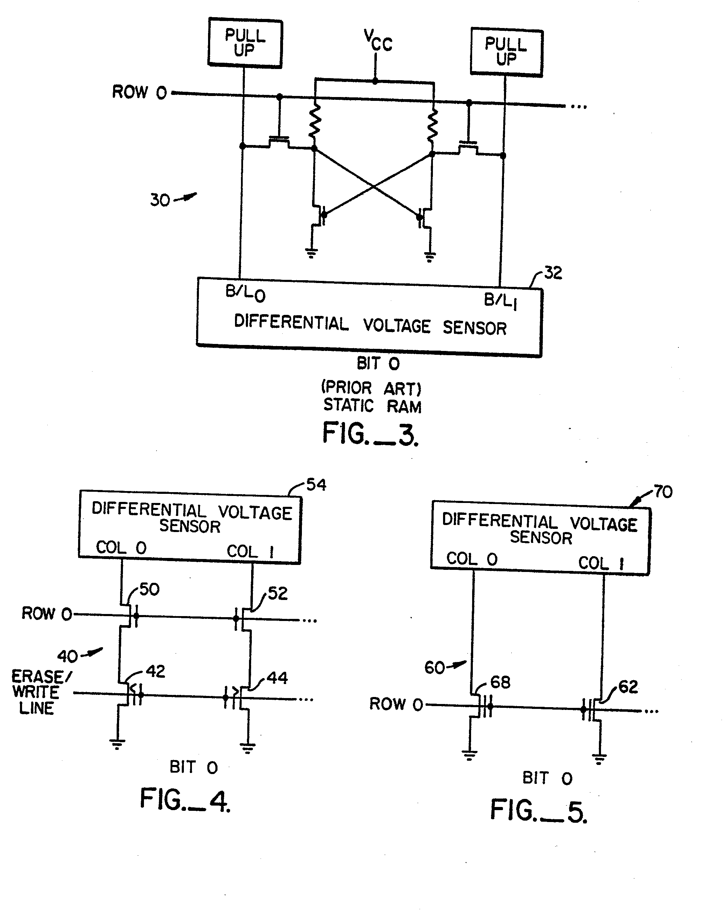

Referring to Fig. 3, there is shown a static RAM 30 of the prior art. The static RAM 30 comprises a plurality of row selectors and a plurality of bit line selectors. Each bit is determined by a row and two bit lines. A plurality of transistors, coupled in a flip-flop like fashion, forms the memory site for each bit. A differential voltage sensor 32 is attached to a pair of bit lines. The sensor 32 senses the voltage in each bit line. The current through each bit line changes the voltage in the line.

Referring to Fig. 4, there is shown an improved memory device 40 of the present invention. The improved memory device 40 has a plurality of addressable storage cells. Two cells, 42 and 44, are shown in Fig. 4. Each cell is of a storage transistor of the EEPROM type in that each cell can store a first amount of electrical charge which affects the conduction of the storage transistor in one manner, and is also capable of storing a second amount of electrical charge which affects the conduction of the storage transistor in another manner. The first amount of charge is different from the second amount of charge. In the improved memory device 40, every two cells are paired together to form a logical storage site, referred to as a bit. In Fig. 4, cells 42 and 44 form the zeroth bit. Although the embodiment shown in 40 shows the cells 42 and 44 as being adjacent, as will be apparent, the cells need not be adjacent to one another. Each cell is selected by its respective select transistor 50 and 52. Thus, cell 42 is selected by select transistor 50 and cell 44 is selected by the select transistor 52. A differential voltage sensor 54 is attached to each bit and measures differentially the voltage from each of the two cells of each bit. With the exception of the differential voltage sensor 54 for each bit, the interconnection of the rows, columns, select transistors and storage cells of the memory device 40 and the manufacture thereof can be identical to the EEPROM 20.

In the write mode, all the cells 42, 44, etc. in each bit are charged so that its respective floating gate becomes charged. Thereafter, one and only one cell of each bit is discharged. The selection of the particular cell to discharge the electrons on the floating gate is determinative of the logical state of the bit. For example, if the first cell 42 is discharged, with the second cell 44 remaining charged, the bit zero is in the logical state "1". On the other hand, if the second cell 44 were discharged and the first cell 42 remain charged then bit zero is in a logical state of "0". The notation can also be interchanged.

In the read mode a low voltage, such as +5V or lower, is placed on the row and the two columns. Thus, both storage transistors of each bit are read simultaneously and a differential voltage sensor 54 senses the difference in the voltage passing from the first cell 42 and the second cell 44. If first cell 42 has its floating gate charged, current will not pass through the first cell 42 as readily as the second cell 44 which does not have as much charge stored on its floating gate. Thus, the differential voltage sensor 54 would detect that more voltage will be across column 0 than from column 1. On the other hand, if more charges were deposited on the floating gate of the second cell 44 than on the floating gate of the first cell 42, then the differential voltage sensor 54 will detect a greater amount of voltage across column 1 than from column 0.

In operation, in the write mode, each row is brought to a source of high potential (such as +21V) with both columns at a low voltage. The write line associated with each row is also brought to the high potential of +21V. The discharge of the selected cell in each pair occurs much like the discharge of the floating gate in an EEPROM device. The selected row and one of the two columns is brought to a source of high potential (+21V) and the associated write line is brought to ground potential. The charging and discharging of the cells of the memory 40 is similar to that for an EEPROM memory 20.

The reading of data from each cell of the memory 40 is similar to that for an EEPROM memory 20. A low voltage such as +5V or lower is connected to the associated row and to the two columns for each bit. It should be noted that both storage cells 42 and 44 are read simultaneously.

As can be seen from Fig. 4, each bit will always comprise a storage cell having one amount of charge with the other storage cell having a different amount of charge. The difference in the combination of which cell having which amount of charge is detected differentially by the differential voltage sensor 54, and is determinative of the state of each bit. This results in a faster read-out. Typical read-out time of 60 nsec. can be achieved, with sensing time about 10-15 nsec.

Referring to Fig. 5, there is shown another embodiment of an improved memory device 60 of the present invention. The improved memory device 60 is identical to the improved memory device 40 except that each of the two storage cells in each bit is of an EPROM type. The improved memory device 60 comprises a plurality of addressable bits, with each bit comprising a first storage cell 68 and a second storage cell 62. Each of the storage cells is of the EPROM type. A differential voltage sensor 70 is attached to each bit and detects the voltage from each column.

In operation of the improved memory device 60, in the write mode, the improved memory device 60 is first exposed to ultra-violet light. This removes the charge from the gate of each of the storage cells 68 and 62. Thereafter, one of the two storage cells, 68 or 62, is charged. A high voltage (+21V) is supplied to the selected column and row.

In the read mode, a low voltage of +5V or lower is applied to both of the columns and to the selected row,

0139185

and the differential sensor 70 detects the amount of voltage, differentially, from the two storage cells 68 and 62. Again, by convention, for example if the first storage cell 68 were charged and the second storage cell 62 were uncharged, then the bit zero would be in a logical state of "1". If the first cell 68 were uncharged and the second cell 62 were charged, then bit zero would be in a logical state of "0". Similar to the improved memory device 40, discussed in Fig. 4, the improved memory device 60 can be read much faster than a conventional EEPROM or EPROM memory device.

From the foregoing, it should be apparent that the two cells forming each bit need not be adjacent to one another. One-half of the cells can be in one integrated chip with the other half in a second integrated chip. Preferably, however, for speed the cells should be adjacent to one another.

It should be emphasized that, with the method and the apparatus of the present invention, although hardware is sacrificed in that each bit requires two storage cells, speed is greatly enhanced. Therefore, in many applications where the erasable or electrically erasable property of the bipolar PROM is desired, as well as speed in the read-out of the data stored in the memory devices being critical, the improved memory devices of the present invention will satisfy those criterion.

## Claims

1.    A method of operating a memory device having a plurality of addressable storage cells, each cell for storing a first amount of electrical charge and for storing a second amount of electrical charge, said first amount different from said second amount, said method comprising the steps of:

forming a plurality of paired cells;

storing a first amount of electrical charge in one of the paired cells and a second amount of electrical charge in the other of the paired cells to represent a first logical state of said paired cell; or a second amount of electrical charge in one of the paired cells and a first amount of electrical charge in the other of the paired cells to represent a second logical state of said paired cell; and

differentially sensing non-destructively the voltage from the one cell and the voltage from the other cell from each paired cell;

whereby said differentially sensed voltage is indicative of the logical state of said paired cell.

2.    The method of Claim 1 wherein said memory device is an Electrically Erasable Programmable Read Only Memory.

3.    The method of Claim 2 wherein each of said storage cells is a storage transistor having a floating gate.

4.    The method of Claim 2 wherein said first amount is greater than said second amount.

5. The method of Claim 4 wherein said storing step further comprises:

storing a first amount in said one cell and said other cell; and

discharging said one or said other cell to reduce the charge therein to the second amount.

6. The method of Claim 1 wherein said memory device is an Electrically Programmable Read Only Memory.

7. The method of Claim 6 wherein each of said storage cells is a storage transistor having a floating gate.

8. The method of Claim 6 wherein said first amount is greater than said second amount, which is substantially near zero.

9. The method of Claim 8 wherein said storing step further comprises:

exposing each cell to ultra-violet electromagnetic radiation to reduce the charge therein to the second amount; and

charging said one or said other cell of each paired cell to increase the charge therein to the first amount.

10. A method of storing electrical charges in a memory device having a plurality of bits, each bit representative of a first or a second logical state and for reading said state therefrom, said memory device having a plurality of storage transistors, means for addressing each transistor for storing electrical charge therein and means for non-destructively reading the amount of charge stored in each transistor; said method comprising the steps of:

forming a plurality of bits, each bit being a pair of storage transistors, each pair having a first and a second transistor;

charging both of said transistors in each bit;

discharging only one of said transistors in each bit; discharging the first transistor for representing the first logical state for said bit or discharging the second transistor for representing the second logical state for said bit; and

non-destructively sensing differentially the amount of voltage from the first and the second transistors;

whereby the amount of differential voltage is representative of the logical state of each bit.

11. A memory device comprising:

a plurality of storage cells, each cell having a first and a second storage transistor means, each transistor means for storing electrical charge of a first amount or of a second amount; each cell for storing charge of a first amount in the first transistor means and charge of a second amount in the second transistor means for representing a first logical state of said cell or for storing charge of a second amount in the first said transistor means and charge of a first amount in the second transistor means for representing a second logical state of said cell; and

means for differentially sensing non-destructively the voltage from the two transistor means from each cell;

0139185

whereby the differentially sensed voltage is representative of the logical state of said cell.

12. The device of Claim 11 wherein each storage transistor means is a storage transistor of the MOS FET type.

13. The device of Claim 12 wherein each transistor is an electrically erasable programmable read only transistor.

14. The device of Claim 12 wherein each transistor is an electrically programmable read-only transistor.

0139185

EPROM
(PRIOR ART)

FIG._1.

EEPROM
(PRIOR ART)

FIG._2.

(PRIOR ART)
STATIC RAM

FIG.__3.

BIT 0

FIG.__4.

BIT 0

FIG.__5.